# EUROPEAN PATENT APPLICATION

(11) **EP 3 605 754 A1**
(43) Date of publication of application: **05.02.2020**
(21) Application number: 18777696.8
(22) Date of filing: 20.03.2018
(51) Int. Cl.: H01S 5/022, G02B 6/28, G02B 6/32, G02B 6/42, G02B 7/00, G02B 7/182, H01S 5/40

(54) **OPTICAL MODULE**

(30) Priority: 31.03.2017 JP 2017071463
(71) Applicant: Fujikura Ltd., Tokyo 135-8512 (JP)
(72) Inventor: KAWAHARA, Yuzuru, Sakura-shi Chiba 285-8550 (JP)
(74) Representative: Plasseraud IP
(86) International application number: PCT/JP2018/011152
(87) International publication number: WO 2018/180807

(57) **Abstract**

An optical module includes: laser diodes (11) that are a plurality of light emitting elements; a plurality of mirrors (13) each having a reflection surface (13r) that reflects each light emitted from each of the light diodes (11); and a submount (4) on which the plurality of laser diodes (11) are arranged on one surface, in which a certain number of mirrors (13) of the plurality of mirrors (13) are arranged at a position overlapping reflected light reflected by another mirror (13) when the one surface of the submount (4) is viewed in plan view, each of the certain number of mirrors (13) has a fixed surface (13f) fixed to the submount (4) with an adhesive, the fixed surface (13f) is perpendicular to the reflection surface (13r), and a fixation surface (40) of the submount (4) to which the fixed surface (13f) is fixed and the fixed surface (13f) are not perpendicular to a direction in which the certain number of mirrors (13) and the reflected light overlap with each other.

## Description

### Technical Field

The present invention relates to an optical module.

### Background Art

As one of optical modules, there is known one in which light emitted from a laser diode is emitted through an optical fiber. In this optical module, an optical fiber is led out from the inside of a casing to the outside of the casing, and optical components such as a laser diode, a mirror, a lens, or an optical fiber are arranged in the casing. The light emitted from each laser diode is condensed and then enters the optical fiber, and is emitted from the optical fiber outside the casing.

For example, Patent Literature 1 below discloses an optical module including a plurality of laser diodes arranged on each step of a step-shaped mount, a plurality of mirrors provided correspondingly to each of the laser diodes, a condenser lens that condenses light reflected by the mirrors, and an optical fiber on which the light condensed in this manner is incident. In such an optical module, a bottom surface of the mirror is fixed to the mount with an adhesive, and when the adhesive expands or contracts due to a change in heat or humidity, the arrangement height of the mirror changes. When the height of the mirror changes as described above, there is a concern that the mirror arranged on the lower stage side of the steps may interfere with the propagation of light reflected by the mirror on the upper stage side.

Therefore, in an optical module disclosed in Patent Literature 2 below, a mirror is fixed with an adhesive in a surface facing an emission surface of a laser diode. By fixing the mirror in this manner, movement of the mirror in the vertical direction of the steps is prevented even if the volume of the adhesive for fixing the mirror changes. For this reason, the mirror arranged at the lower stage side of the steps can be prevented from interfering with propagation of the light reflected by the mirror by the mirror on the upper stage side.

[Patent Literature 1] JP 2016-164671 A
[Patent Literature 2] JP 5730814 B2

### Summary of Invention

However, in the optical module disclosed in Patent Literature 2, when the volume of the adhesive fixing the mirror changes due to a change in heat or humidity, the reflection surface of the mirror is displaced along the optical axis direction of the light emitted from the laser diode. When the reflection surface is displaced in this manner, the emission position of the light reflected by the mirror is shifted, and the optical path of the reflected light is changed. If the optical path of the reflected light changes, for example, when the light is condensed by a condenser lens, there is a concern that the light cannot be condensed as designed.

Then, an object of the present invention is to provide an optical module in which a change of an optical path by heat or humidity can be prevented.

An optical module according to the present invention is characterized by including: a plurality of light emitting elements; a plurality of mirrors each having a reflection surface that reflects each light emitted from each of the light emitting elements; and a mount on which the plurality of light emitting elements are arranged on a side of one surface, in which a certain number of mirrors of the plurality of mirrors are arranged at a position overlapping with reflected light reflected by another of the mirrors when the one surface of the mount is viewed in plan view, the certain number of mirrors have a fixed surface fixed to the mount with an adhesive, the fixed surface is perpendicular to the reflection surface, and a fixation surface of the mount to which the fixed surface is fixed and the fixed surface are not perpendicular to a direction in which the certain number of mirrors and the reflected light overlap with each other when the one surface of the mount is viewed in plan view.

For example, in a case where the fixed surface of the mirror and the fixation surface to which the fixed surface is fixed are perpendicular to the direction in which the mirror and the reflected light reflected by another mirror overlap with each other, when the volume of the adhesive fixing the fixed surface changes, the mirror is displaced in a direction substantially perpendicular to the fixed surface and the fixation surface. That is, the mirror is displaced in the direction of the reflected light reflected by another mirror. As a result, the distance between the mirror and the reflected light reflected by another mirror becomes smaller, and if the displacement of the mirror becomes large, the propagation of the reflected light may be disturbed. However, in the optical module, the fixed surface of the mirror and the fixation surface of the mount are not perpendicular to the direction in which the mirror and the reflected light reflected by another mirror overlap with each other. For this reason, when the volume of the adhesive fixing the fixed surface changes, the direction in which the mirror is displaced is different from the direction in which the mirror and the reflected light reflected by another mirror overlap with each other. That is, displacement of the mirror in the direction approaching the reflected light reflected by another mirror is prevented as compared with the above example. Therefore, the light propagation can be prevented from being disturbed by the volume change of the adhesive fixing the mirror. By preventing the displacement of the mirror in the direction approaching the reflected light reflected by the other mirror as described above, the interval between the mirror and the reflected light reflected by the other mirror can be narrowed. Therefore, the installation intervals of the plurality of mirrors can be narrowed, and the plurality of pieces of reflected light can be easily arrayed densely. Further, in the optical module described above, the fixed surface of the mirror is perpendicular to the reflection surface, so that when the mirror is displaced due to the volume change of the adhesive fixing the fixed surface as described above, the reflection surface is displaced mainly in the same plane. For this reason, even when the reflection surface is displaced, it is possible to prevent the change in the distance between the light emitting element and the reflection surface, and an entrance angle of the light from the light emitting element on the reflection surface. Therefore, the emission position of the light reflected by the mirror can be prevented from shifting due to the volume change of the adhesive fixing the mirror. As described above, in the optical module described above, even if the volume of the adhesive fixing the mirror changes by heat or humidity, the change in the optical path can be prevented.

It is preferable that the fixation surface and the fixed surface be parallel to a direction in which the certain number of mirrors and the reflected light overlap with each other.

The fixation surface and the fixed surface are parallel to the direction in which the mirror and the reflected light overlap with each other, so that when the volume of the adhesive fixing the fixed surface changes, the mirror is displaced in a direction substantially perpendicular to the direction in which the mirror and the reflected light overlap with each other. For this reason, even if the volume of the adhesive fixing the mirror changes, the displacement of the mirror in the direction approaching the reflected light is further prevented. Therefore, the light propagation can be further prevented from being disturbed by the volume change of the adhesive fixing the mirror.

Further, it is preferable that the one surface of the mount is formed in a step shape, and the plurality of light emitting elements are arranged one by one on each step of the mount formed in a step shape, and the fixation surface be formed on a side wall formed between adjacent steps.

By arranging each of the light emitting elements on each of the steps of the step-shaped mount in this manner, the respective pieces of light emitted from the respective light emitting elements can be easily arrayed in one direction and emitted. In this case, the direction in which the certain number of mirrors and the reflected light reflected by another mirror overlap with each other can be a direction perpendicular to the surface on which the light emitting element is arranged. Since the side wall formed between adjacent steps is not parallel to the surfaces constituting these steps, a part of the side wall is used as the fixation surface, so that the fixation surface is not parallel to the surface on which the light emitting element is arranged. Therefore, the fixation surface to which the mirror is fixed is not perpendicular to the direction in which the mirror and the reflected light reflected by another mirror overlap with each other, and as described above, the light propagation can be prevented from being disturbed due to the volume change of the adhesive fixing the mirror.

Alternatively, it is preferable that the plurality of light emitting elements be arranged on the same plane, and the fixation surface be formed on a side surface non-parallel to the plane among projections projecting to the side on which the mirror is provided from the plane.

In the case where a plurality of light emitting elements are arranged on the same plane, a fixation surface to which the fixed surface of the mirror is fixed is formed on the side surface of the projection provided as described above, so that the fixation surface is not perpendicular to the direction in which the mirror and the reflected light reflected by another mirror overlap with each other. Therefore, the light propagation can be prevented from being disturbed by the volume change of the adhesive fixing the mirror as described above.

It is preferable that the fixation surface is not parallel to the optical axis of the light emitted from the light emitting element.

As described above, the reflection surface and the fixed surface of the mirror are perpendicular to each other. Therefore, when the fixed surface is parallel to the optical axis of the light emitted from the light emitting element, the reflection surface of the mirror is perpendicular to the optical axis of the light emitted from the light emitting element. Here, as described above, the fixation surface is not parallel to the optical axis of the light emitted from the light emitting element, so that the fixation surface and the fixed surface are fixed in parallel with each other, and the reflection surface can be inclined at a predetermined angle with respect to the optical axis of the light emitted from the light emitting element. Note that, since the fixation surface and the fixed surface are parallel with each other as described above, the thickness of the adhesive fixing the fixed surface can be made uniform, so that the displacement of the mirror due to the volume change of the adhesive is easy to be restricted in the direction perpendicular to the fixed surface.

Further, it is preferable that a collimating lens for collimating light emitted from the light emitting element be provided between the light emitting element and the mirror, and the collimating lens and the mirror be fixed to an integrally formed surface.

By fixing the collimating lens and the mirror to the integrally formed surface, the relative positional shift between the collimating lens and the mirror can be prevented.

Further, it is preferable that the direction in which the certain number of mirrors and the reflected light overlap with each other is a direction perpendicular to the one surface of the mount.

As described above, according to the present invention, there is provided an optical module in which a change of an optical path by heat or humidity can be prevented.

### Brief Description of Drawings

FIG. 1 is a perspective view showing an optical module according to a first embodiment of the present invention.
FIG. 2 is a view of the optical module shown in FIG. 1 from which a lid is removed.
FIG. 3 is a plan view showing a part of the optical module shown in FIG. 2 in an enlarged manner.
FIG. 4 is a side view showing the same part as that of FIG. 3 in the optical module shown in FIG. 2.
FIG. 5 is a front view of the mirror shown in FIG. 2 from a reflection surface side.
FIG. 6 is a view showing spread of light incident on an incident surface of a condenser lens shown in FIG. 2.
FIG. 7 is a view showing an optical module according to a second embodiment of the present invention from the same viewpoint as FIG. 2.
FIG. 8 is a cross-sectional view of the optical module taken along line VIII-VIII shown in FIG. 7.
FIG. 9 is a cross-sectional view of the optical module taken along line IX-IX shown in FIG. 7.
FIG. 10 is a plan view showing an optical path of light reflected by the mirror shown in FIG. 7.
FIG. 11 is a side view showing the optical path of light reflected by the mirror shown in FIG. 7.
FIG. 12 is a view showing an optical module according to a modification of the present invention from the same viewpoint as FIG. 3.
FIG. 13 is a view showing an optical module according to another modification of the present invention from the same viewpoint as FIG. 3.

### Description of Embodiments

Hereinafter, preferred embodiments of an optical module according to the present invention will be described in detail with reference to the drawings.

### (First Embodiment)

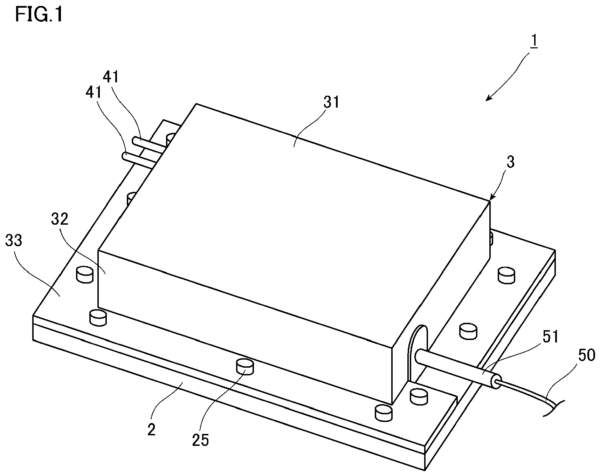

FIG. 1 is a perspective view showing an optical module according to the present embodiment. As shown in FIG. 1, an optical module 1 of the present embodiment includes a casing composed of a base plate 2 and a lid 3, an optical component described later that is fixed in the casing, and a connector 41 that supplies power to some optical components.

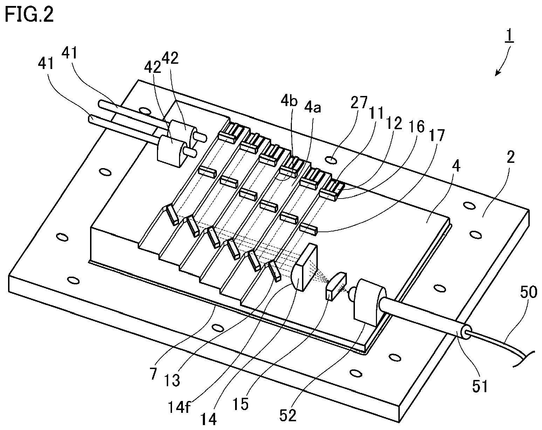

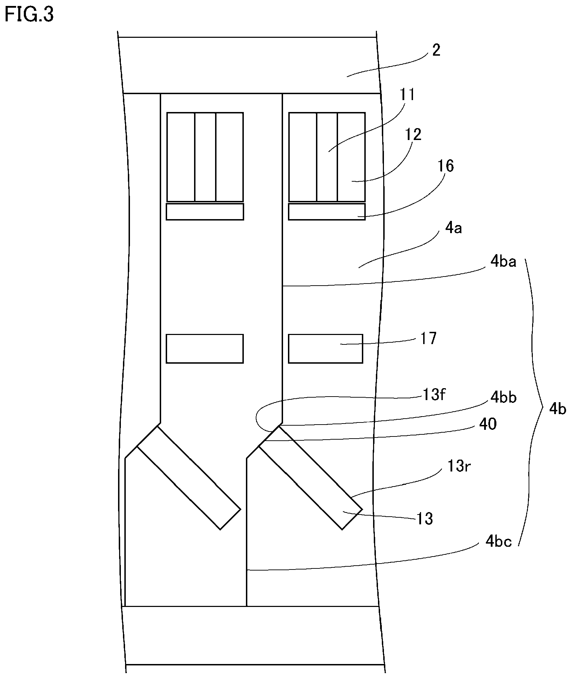

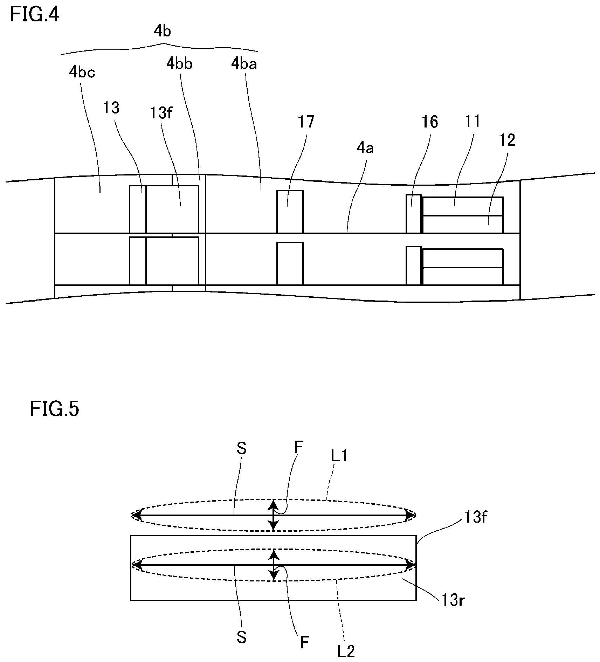

FIG. 2 is a view of the optical module 1 shown in FIG. 1 from which the lid 3 is removed. In FIG. 2, an optical path of light emitted from a laser diode 11 is shown by a broken line. FIG. 3 is a plan view showing a part of the optical module 1 shown in FIG. 2 in an enlarged manner, and FIG. 4 is a side view showing the same part as that in FIG. 3 in the optical module shown in FIG. 2.

A base plate 2 is a flat plate whose bottom surface which is a bottom plate of the casing, and in the present embodiment, is a flat member as shown in FIG. 2. The base plate 2 is made of metal, and examples of the metal constituting the base plate 2 include copper and stainless steel. A plurality of screw holes 27 are formed in the outer circumferential portion of the base plate 2.

A submount 4 is fixed on the base plate 2 by a solder 7. The submount 4 has a flat bottom surface on the base plate 2 side, and a surface on the opposite side to the base plate 2 is formed in a step shape. That is, the surface of the submount 4 opposite to the base plate 2 is formed in a step shape by a plurality of parallel surfaces 4a parallel to the bottom surface of the submount 4 and side walls 4b formed between the parallel surfaces 4a adjacent to each other. In the present embodiment, the side wall 4b is a surface perpendicular to the parallel surface 4a. As shown in FIGS. 3 and 4, the side wall 4b has three surfaces integrally formed. Specifically, the side wall 4b includes a first surface 4ba and a third surface 4bc formed parallel to an optical axis of the light emitted from the laser diode 11, and a second surface 4bb formed between the first surface 4ba and the third surface 4bc. The second surface 4bb is inclined at a predetermined angle with respect to the optical axis of the light emitted from the laser diode 11. In the present embodiment, the second surface 4bb is inclined at 45° with respect to the optical axis of the light emitted from the laser diode 11. The second surface 4bb is a surface that cannot be viewed when the light emitting direction is viewed from the laser diode 11. As shown in FIG. 3, the second surface 4bb is a portion where a fixation surface 40 to which a fixed surface 13f of a mirror 13 is fixed is formed.

The submount 4 is made of a material having a smaller linear expansion coefficient than the base plate 2. For example, when the base plate 2 is made of copper, the submount 4 is made of aluminum nitride. The submount 4 is made of a material having a small linear expansion coefficient as described above, so that the optical properties of the optical module 1 can be prevented from changing due to the expansion of the submount 4 due to the heat generated by the optical component arranged on the submount 4.

The submount 4 is a mount in which an optical component including an optical fiber 50 is arranged on one surface side. The optical component of the present embodiment includes the laser diode 11 that is a light emitting element, a first collimating lens 16, a second collimating lens 17, the mirror 13, a first condenser lens 14, a second condenser lens 15, and an optical fiber 50.

The plurality of laser diodes 11 are arranged one by one on each step of the submount 4 in which one surface is formed in a step shape as described above. Each laser diode 11 is an element having a Fabry-Perot structure in which a plurality of semiconductor layers including an active layer are vertically stacked with respect to the parallel surface 4a. Therefore, the laser diode 11 emits laser light whose direction perpendicular to the parallel surface 4a is a fast axis and whose direction parallel to the parallel surface 4a is a slow axis. Each laser diode 11 emits, for example, a laser beam of a wavelength band of 900 nm. In the present embodiment, each laser diode 11 is fixed on the laser mount 12 by soldering or the like, and is fixed on the parallel surface 4a of the submount 4 via the laser mount 12.

The laser mount 12 is a table for adjusting the height of the laser diode 11, and each laser mount 12 is fixed at a position on the outer circumferential side of the submount 4 by, for example, soldering. Note that the laser mount 12 may be separated from the submount 4 and the laser mount 12 may be fixed on the submount 4 as described above, or the laser mount 12 may be integrally molded with the submount 4. Alternatively, if height adjustment of the laser diode 11 is unnecessary, the laser mount 12 may be omitted.

The first collimating lens 16 is a lens that collimates the light in the fast axis direction of the light emitted from the laser diode 11. The first collimating lens 16 is fixed on the laser mount 12 by resin or the like so that the relative position with the laser diode 11 is fixed.

The second collimating lens 17 is a lens that collimates the light in the slow axis direction of the light emitted from the laser diode 11. The second collimating lens 17 is fixed on the parallel surface 4a of the submount 4 by adhesive or the like.

Each mirror 13 is provided on the light emission direction side of each laser diode 11. One mirror 13 is provided for one laser diode 11. Therefore, each mirror 13 can directly reflect the light emitted from the laser diode 11 and collimated. Further, as shown in FIG. 2 to FIG. 4, each mirror 13 has a reflection surface 13r for reflecting light from the laser diode 11, and the fixed surface 13f fixed to the fixation surface 40 of the submount 4 with an adhesive. As shown in FIG. 2, a certain number of mirrors 13 of the plurality of mirrors 13 are arranged at a position overlapping with the reflected light reflected by another mirror 13 in the direction perpendicular to the parallel surface 4a of the submount 4. In other words, the direction in which the certain number of mirrors 13 and the reflected light reflected by another mirror 13 overlap with each other is the direction perpendicular to the parallel surface 4a that is one surface of the submount 4. That is, the certain number of mirrors 13 of the present embodiment is arranged at a position overlapping the reflected light reflected by another mirror 13 when one surface of the submount 4 is viewed in plan. As described above, each laser diode 11 emits light whose direction perpendicular to the parallel surface 4a is the fast axis. For this reason, the certain number of mirrors 13 are arranged in line with the reflected light reflected by another mirror 13 in the fast axis direction of the light incident on the reflection surface 13r of each mirror 13. In the present embodiment, the certain number of mirrors 13 are mirrors 13 excluding the mirror 13 arranged at the top of the step-shaped submount 4 among the plurality of mirrors 13. That is, the certain number of mirrors 13 are all the mirrors 13 excluding the mirror 13 arranged at a position farthest from the first condenser lens 14.

FIG. 5 is a front view of one mirror 13 among the certain number of mirrors 13 from the reflection surface 13r side. FIG. 5 shows the front view of one mirror 13, the spread of light L2 that is the reflected light reflected by the mirror 13, and the spread of light L1 that is the reflected light propagating most closely to the one mirror 13 among the pieces of reflected light reflected by another mirror 13. S shown in FIG. 5 means the slow axis of the light L1, L2, and L means the fast axis. As shown in FIG. 5, the mirror 13 is arranged in line with the light L1 reflected by another mirror 13 in the fast axis F direction of the light L2 reflected by the reflection surface 13r. The mirror 13 of the present embodiment is arranged in line with the light L1 in the fast axis F direction of the light L1 propagating most closely among pieces of reflected light reflected by another mirror 13. The fixed surface 13f of the mirror 13 of the present embodiment is formed parallel to the direction in which the mirror 13 and the light L1 reflected by another mirror overlap with each other.

The fixed surfaces 13f of each mirror 13 are perpendicular to the reflection surface 13r. The fixed surface 13f is fixed to the fixation surface 40 that is a part of the second surface 4bb of the side wall 4b by an adhesive. The second surface 4bb in the present embodiment is a surface perpendicular to the parallel surface 4a on which the laser diode 11 is arranged, and fixation is performed so that the fixed surface 13f and the fixation surface 40 are parallel to each other, and thereby, the fixed surface 13f is a surface perpendicular to the parallel surface 4a. As described above, the second surface 4bb is inclined at a predetermined angle with respect to the optical axis of the light emitted from the laser diode 11. Therefore, the fixation surface 40 and the fixed surface 13f are parallel to each other, so that the reflection surface 13r is inclined at a predetermined angle with respect to the optical axis of the light emitted from the laser diode 11. In the present embodiment, the second surface 4bb is inclined at 45° with respect to the optical axis of the light emitted from the laser diode 11 as described above. Therefore, fixation is performed so that the fixation surface 40 and the fixed surface 13f are parallel to each other, so that the reflection surface 13r perpendicular to the fixed surface 13f is inclined at 45° with respect to the optical axis of the light emitted from the laser diode 11.

As described above, the second surface 4bb is a surface that cannot be viewed when the light emitting direction is viewed from the laser diode 11. Therefore, the fixed surface 13f fixed to the fixation surface 40 that is a part of the second surface 4bb is arranged at a position out of the straight line overlapping the optical axis of the light emitted from the laser diode 11 and incident on the reflection surface 13r.

The mirror 13 of the present embodiment as described above is a glass body in which the reflection surface 13r is formed on the surface by a reflecting film made of, for example, a dielectric multilayer film. Note that the reflection surface 13r may be formed of a metal film.

Each of the first condenser lens 14 and the second condenser lens 15 is formed of a cylindrical lens, and is fixed to the submount 4 by adhesion. The first condenser lens 14 condenses the light reflected by each mirror 13 in the fast axis direction, and the second condenser lens 15 condenses the light emitted from the first condenser lens 14 in the slow axis direction. Note that, when the light emitted from these condenser lenses is not condensed at a desired position, another condenser lens may be further arranged on the submount 4.

The optical fiber 50 is inserted into a pipe-shaped holder 51 and fixed to the holder 51. In the present embodiment, one end as the light incident end of the optical fiber 50 is slightly led out from the holder 51. The holder 51 is fixed to a fiber mount 52, and the fiber mount 52 is fixed to the submount 4. One end of the optical fiber 50 is located at a position where light emitted from the second condenser lens 15 can enter the core. In the present embodiment, the optical fiber 50 is fixed to the holder 51 by an adhesive or soldering, the holder 51 is fixed by being adhered to the fiber mount 52, and the fiber mount 52 is fixed to the submount 4 by adhesion.

A connector 41 is formed of a pair of rod-shaped conductors, and each of the conductors is fixed to a pair of connector holders 42. Each connector holder 42 is adhered and fixed to the submount 4. One conductor of the connector 41 is connected to the laser diode 11 closest to the connector 41 by a gold wire (not shown), and each laser diode 11 is daisy chained by a gold wire (not shown). The laser diode 11 farthest from the connector 41 is connected to the other conductor of the connector 41 by a gold wire (not shown).

The lid 3 is formed by pressing a metal plate and, as shown in FIG. 1, includes a top plate 31, a frame 32, and a collar 33. The top plate 31 is a portion to be a top plate of a casing and is formed of a flat plate-shaped member. The frame 32 is a portion vertically connected to the top plate 31 at the periphery of the top plate 31. The frame 32 is sized to surround the submount 4, the optical components on the submount 4, or the like in a state in which the lid 3 is arranged on the base plate 2. The frame 32 and the collar 33 are formed with a notch for leading the optical fiber 50 from the inside of the casing to the outside of the casing, and a notch for leading the connector 41 from the inside of the casing to the outside of the casing. A plurality of screw holes are formed in the collar 33, and a screw 25 is screwed into the screw holes and each screw hole 27 of the base plate 2, so that the base plate 2 and the lid 3 are fixed.

Next, the optical operation of the optical module 1 will be described.

When the desired power is supplied from the connector 41 to each laser diode 11, as shown in FIG. 2, each laser diode 11 emits light toward each first collimating lens 16 corresponding to each laser diode 11. As described above, this light is, for example, a laser beam of a wavelength band of 900 nm. The light emitted from each laser diode 11 has a fast axis direction orthogonal to the parallel surface 4a which is a plane on which each laser diode 11 is arranged, and a slow axis direction parallel to the parallel surface 4a.

Each first collimating lens 16 collimates the light emitted from each laser diode 11 in the fast axis direction and emits the light. Each second collimating lens 17 collimates the light emitted from each first collimating lens 16 in the slow axis direction and emits the light. The light emitted from each second collimating lens 17 is incident on each corresponding mirror 13, and is reflected by each mirror 13. In the present embodiment, as described above, since the reflection surface 13r of the mirror 13 is inclined by 45° with respect to the optical axis of the light emitted from the laser diode 11, the light incident on the mirror 13 is vertically reflected. The light reflected by the plurality of mirrors 13 is incident on the first condenser lens 14.

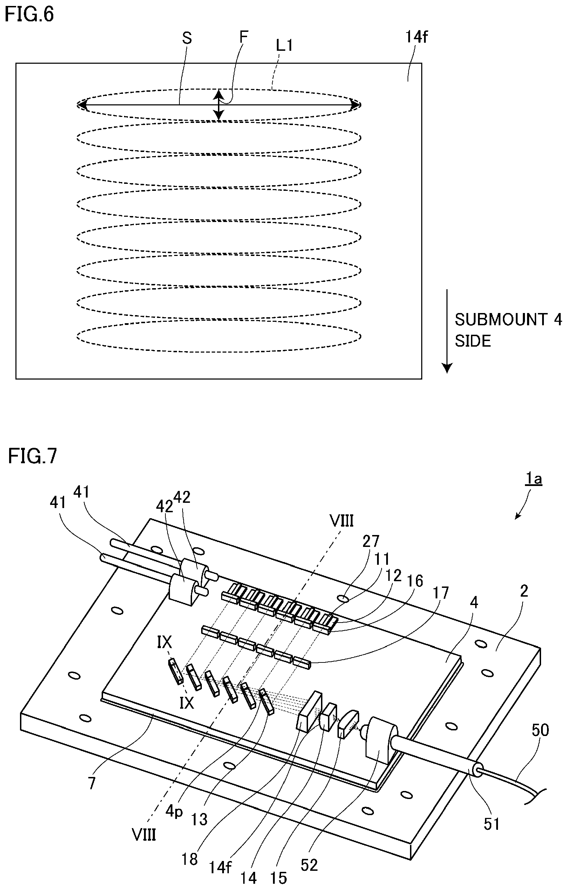

FIG. 6 is a view showing spread of light incident on an incident surface 14f of the first condenser lens 14 shown in FIG. 2. Each laser diode 11 is arranged on each step of the submount 4 formed in a step shape as described above. Therefore, each light L1 emitted from the plurality of laser diodes 11 and reflected by the plurality of mirrors 13 is arrayed so that the fast axis F directions are aligned when each light L1 is incident on the incident surface 14f of the first condenser lens 14. The light in the fast axis F direction emitted from the laser diode 11 is of a single mode and is easily collimated by the first collimating lens 16, and the light in the slow axis S direction is of a multi-mode and is difficult to be collimated in the second collimating lens 17 as compared to the light in the fast axis F direction. For this reason, as shown in FIG. 6, the light L1 incident on the first condenser lens 14 is light whose spread in the fast axis F direction is smaller than the slow axis S direction.

The light incident on the first condenser lens 14 is condensed in the fast axis direction as described above. The light emitted from the first condenser lens 14 is incident on the second condenser lens 15, and the slow axis direction of the light is condensed by the second condenser lens 15. The light condensed by the second condenser lens 15 enters the core of the optical fiber 50 and propagates through the optical fiber 50. Thus, light is emitted from the other end of the optical fiber 50.

Next, the operation of the optical module 1 will be described.

The optical module 1 includes laser diodes 11 that are a plurality of light emitting elements, and a plurality of mirrors 13, each of which reflects each light emitted from each of the laser diodes 11. Each mirror 13 has a fixed surface 13f that is formed perpendicular to the reflection surface 13r and fixed to the fixation surface 40 of the submount 4 with an adhesive. The certain number of mirrors 13 among the plurality of mirrors 13 are arranged at a position overlapping the reflected light reflected by another mirror 13 when one surface of the submount 4 is viewed in plan as described above. The fixed surface 13f of the certain number of mirrors 13 and the fixation surface 40 to which the fixed surface 13f is fixed of the present embodiment are parallel to the direction in which the mirror 13 and the reflected light overlap with each other.

When the heat generated at the time of light emission of the laser diode 11 is transmitted to the adhesive fixing the fixed surface 13f of the mirror 13 through the submount 4 or the like, and the volume of the adhesive changes, the mirror 13 is mainly displaced in a direction substantially perpendicular to the fixed surface 13f. In the present embodiment, as described above, the fixed surface 13f of the certain number of mirrors 13 and the fixation surface 40 to which the fixed surface 13f is fixed are parallel to the direction in which the mirror 13 and the reflected light reflected by another mirror 13 overlap with each other. For this reason, when the volume of the adhesive fixing the fixed surface 13f changes and the fixed surface 13f is displaced in the vertical direction, the mirror 13 is displaced in the direction perpendicular to the direction in which the mirror 13 and the reflected light overlap with each other. Therefore, the displacement of the mirror 13 in the direction approaching the reflected light reflected by another mirror 13 can be prevented, and the propagation of the reflected light reflected by another mirror 13 can be prevented from being disturbed due to the volume change of the adhesive fixing the mirror 13. By preventing the displacement of the mirror 13 in the direction approaching the reflected light reflected by another mirror 13 as described above, the interval between the mirror 13 and the reflected light reflected by another mirror 13 can be narrowed. Therefore, the installation intervals of the plurality of mirrors 13 can be narrowed, and the plurality of pieces of reflected light can be easily arrayed densely in one direction. In the present embodiment, the plurality pieces of reflected light can be easily arrayed densely so that the fast axis directions are aligned.

Further, in the optical module 1, the fixed surface 13f of the mirror 13 is perpendicular to the reflection surface 13r, so that when the mirror 13 is displaced due to the volume change of the adhesive fixing the fixed surface 13f as described above, the reflection surface 13r is displaced mainly in the same plane. For this reason, even if the reflection surface 13r is displaced, the distance between the laser diode 11 and the reflection surface 13r and the entrance angle of the light from the laser diode 11 to the reflection surface 13r are prevented from changing. Therefore, the emission position of the light reflected by the mirror 13 is prevented from shifting due to the volume change of the adhesive fixing the mirror 13. For example, as in the optical module disclosed in Patent Literature 2, a case is assumed where the mirror is fixed with an adhesive on the surface facing the emission surface of the laser diode. In this case, when the volume of the adhesive fixing the mirror changes, the reflection surface of the mirror is displaced along the optical axis direction of the light emitted from the laser diode. When the reflection surface is displaced in this manner, the emission position of the light reflected by the mirror is shifted, and the optical path of the reflected light is changed. When light having a slow axis parallel to the surface on which the laser diode is arranged is emitted from the laser diode as in the present embodiment, if the reflection surface is displaced as in the optical module disclosed in Patent Literature 2, the optical path of light after being reflected by the reflection surface is easily shifted in the slow axis direction. In the present embodiment, the light reflected by the mirror 13 can be prevented from shifting in the slow axis direction.

As described above, in the optical module 1, even if the volume of the adhesive fixing the mirror 13 changes, the change in the optical path can be prevented. Therefore, in the optical module 1, changes in the optical path due to heat or humidity can be prevented.

In the optical module 1, the plurality of laser diodes 11 are arranged one by one on each stage of the submount 4 formed in a step shape. By arranging the plurality of laser diodes 11 in this manner, light emitted from each of the plurality of laser diodes 11 can be easily arrayed in the fast axis direction and emitted.

The fixed surface 13f of each mirror 13 is fixed to the side wall 4b formed between the parallel surfaces 4a adjacent to each other. In the present embodiment, since the side wall 4b formed between adjacent steps is perpendicular to the parallel surfaces 4a constituting these steps, when the fixed surface 13f of the mirror 13 is fixed to the side wall 4b, the fixed surface 13f is perpendicular to the parallel surface 4a constituting these steps. In the present embodiment, the direction in which the certain number of mirrors 13 and the reflected light reflected by another mirror 13 overlap with each other is the direction perpendicular to the parallel surface 4a on which the laser diode 11 is arranged. Therefore, the fixed surface 13f of the mirror 13 is parallel to the direction in which the mirror 13 and the reflected light reflected by another mirror 13 overlap with each other, and as described above, the light propagation can be prevented from being disturbed due to the volume change of the adhesive fixing the mirror 13.

As described above, the reflection surface 13r and the fixed surface 13f of the mirror 13 are perpendicular to each other. Therefore, when the fixed surface 13f is parallel to the optical axis of the light emitted from the laser diode 11, the reflection surface 13r of the mirror 13 is perpendicular to the optical axis of the light emitted from the laser diode 11. Here, in the optical module 1, the fixation surface 40 to which the fixed surface 13f of the mirror 13 is fixed as described above is not parallel to the optical axis of the light emitted from the laser diode 11. For this reason, by fixing the fixation surface 40 and the fixed surface 13f in parallel each other, the reflection surface 13r can be inclined at a predetermined angle with respect to the optical axis of the light emitted from the laser diode 11. Since the fixation surface 40 to which the fixed surface 13f is fixed and the fixed surface 13f are parallel with each other, the thickness of the adhesive fixing the fixed surface 13f can be made uniform, so that the displacement of the mirror 13 due to the volume change of the adhesive is easy to be restricted in the direction perpendicular to the fixed surface 13f.

In the optical module 1, the mirror 13 is arranged so that the fixed surface 13f deviates from the straight line overlapping with the optical axis of the light emitted from the laser diode 11. By arranging the fixed surface 13f in this manner, even if the light emitted from the laser diode 11 passes through the mirror 13 or the heat of the light is transmitted to the mirror 13, the adhesive fixing the fixed surface 13f is prevented from being heated. For this reason, the volume change and damage by the heat of the adhesive can be prevented. Note that, in the present embodiment, as described above, the fixation surface 40 to which the fixed surface 13f of the mirror 13 is fixed is a surface that cannot be viewed when the light emission direction is viewed from the laser diode 11. Therefore, it is easy to fix the mirror 13 so that the fixed surface 13f deviates from the straight line overlapping with the optical axis of the light emitted from the laser diode 11. From the viewpoint of preventing the heating of the adhesive for fixing the mirror 13 in this manner, it is preferable that the mirror 13 be fixed so that the fixed surface 13f is sufficiently separated from the straight line overlapping with the optical axis of the light emitted from the laser diode 11.

As described above, the respective pieces of light emitted from the plurality of laser diodes 11 are arrayed so that the fast axis directions are aligned after the respective pieces of light are reflected by the plurality of mirrors 13. Among pieces of the light emitted from the laser diodes 11, the light in the fast axis direction is easier to be collimated than light in the slow axis direction as described above. For this reason, by arraying the pieces of light emitted from the plurality of laser diodes 11 and collimated so that the fast axis directions are aligned, the pieces of light are easily collected densely in space. Therefore, in the optical module 1, the light emitted from the plurality of laser diodes 11 can be densely collected in space. Therefore, the optical module 1 can emit light with high output. Thus, in the optical module 1, multiplexed light with high brightness can propagate through the optical fiber 50.

In the optical module 1, each light reflected by each mirror 13 is reflected in the direction in which the plurality of mirrors 13 are arrayed in parallel as viewed from the fast axis direction. In this manner, each light is reflected by each mirror 13 so that each light reflected by each mirror 13 can be prevented from being shifted in the slow axis direction. Therefore, each light reflected by each mirror 13 can be condensed in a narrow region.

In the optical module 1, each mirror 13 is arranged on each step of the submount 4 formed in a step shape, and the displacement of the mirror 13 in the vertical direction of the step is prevented as described above. Accordingly, the light reflected by each mirror 13 can be prevented from being blocked by another mirror 13. The light is reflected by each mirror 13 as described above so that the light emitted from the plurality of laser diodes 11 can be efficiently used. Therefore, the light emitted from the plurality of laser diodes 11 can efficiently enter the optical fiber 50.

### (Second Embodiment)

Next, a second embodiment of the present invention will be described in detail with reference to FIG. 7. Note that the same or equivalent constituent elements as those of the first embodiment are denoted by the same reference numerals, and redundant explanation will be omitted except when particularly described.

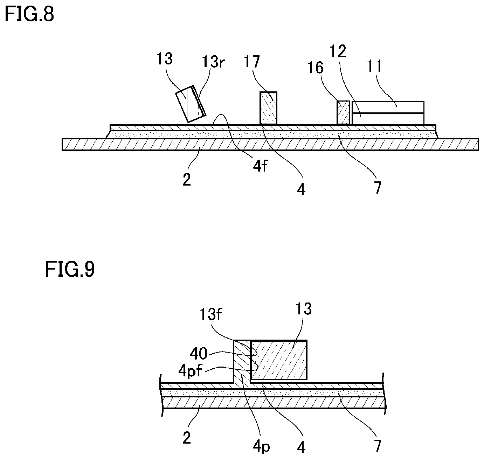

FIG. 7 is a view showing an optical module 1a according to a second embodiment of the present invention from the same viewpoint as FIG. 2. FIG. 8 is a cross-sectional view of the optical module 1a taken along line VIII-VIII shown in FIG. 7. FIG. 9 is a cross-sectional view of the optical module 1a taken along line IX-IX shown in FIG. 7.

The submount 4 of the present embodiment is different from the first embodiment in that it is a flat substrate excluding the portions where a plurality of projections 4p are formed. The submount 4 of the present embodiment has a flat bottom surface on the base plate 2 side, and has the plurality of projections 4p in a surface 4f on the opposite side to the base plate 2. In the present embodiment, the plurality of laser diodes 11 are arranged on a planar portion of the surface 4f of the submount 4. Accordingly, the plurality of laser diodes 11 are arranged on the same plane.

Each of the projections 4p projects from the surface 4f that is a flat portion of one surface of the submount 4 to the side on which the mirror 13 is provided. In the present embodiment, each of the projections 4p is formed to project in the direction perpendicular to the surface on which the laser diode 11 is arranged. The projection 4p of the present embodiment is a portion integrally formed with the other portion of the submount 4 by cutting or the like. However, the projection 4p may be formed separately from the other portion of the submount 4 and then integrated with the submount 4 by press fitting or the like to be a part of the submount 4. The submount 4 may be formed by integrating a plurality of members in this way. The optical component fixed on the submount 4 of the present embodiment includes a light refracting member 18 in addition to the laser diode 11, the first collimating lens 16, the second collimating lens 17, the mirror 13, the first condenser lens 14, the second condenser lens 15, and the optical fiber 50.

In the present embodiment, the fixed surface 13f of each mirror 13 is fixed to the fixation surface 40 that is a part of a side surface 4pf of the projection 4p, as shown in FIG. 9. As similar to the second surface 4bb of the first embodiment, the side surface 4pf of the present embodiment is perpendicular to the surface 4f of the submount 4, and is inclined at a predetermined angle with respect to the optical axis of the light emitted from the laser diode 11. As shown in FIG. 8, each mirror 13 is fixed so that the reflection surface 13r is inclined to the normal of the surface 4f of the submount 4 on which the laser diode 11 is arranged. By the inclination of the reflection surface 13r in this manner, as described in detail later, the plurality of mirrors 13 can reflect each light emitted from each laser diode 11 so that the fast axis directions are aligned with each other and arrayed. In the present embodiment, the plurality of mirrors 13 are arranged such that the light reflected by each mirror 13 can be prevented from being blocked by another mirror 13.

The light refracting member 18 is provided between the plurality of mirrors 13 and the first condenser lens 14, and is fixed to the submount 4 by adhesion. The light refracting member 18 refracts light such that propagation directions of respective pieces of light reflected by the plurality of mirrors 13 approach parallel to the optical axis of the first condenser lens 14. In the light refracting member 18 of the present embodiment, the surface on the mirror 13 side and the surface on the first condenser lens 14 side are formed non-parallel. The light refracting member 18 has a bottom surface to be fixed to the submount 4, the surface of the light refracting member 18 that is the side of the first condenser lens 14 is formed perpendicular to the bottom surface, and the surface that is the side of the mirror 13 is formed such that the angle formed with the bottom surface is acute. Therefore, in a state where the bottom surface of the light refracting member 18 is fixed in parallel to the surface 4f of the submount 4, the distance from a point where the light reflected by the plurality of mirrors 13 enters the light refracting member 18 to a point where the light transmits through the light refracting member 18 is smaller as it is further away from the submount 4. The light refracting member 18 as described above is a wedge substrate and is made of, for example, glass.

In the present embodiment, the first condenser lens 14 and the second condenser lens 15 are arranged such that the optical axis of the first condenser lens 14 and the optical axis of the second condenser lens 15 are parallel to the surface on which the plurality of laser diodes 11 are arranged. In the present embodiment, the first condenser lens 14 and the second condenser lens 15 are arranged such that the optical axis of the first condenser lens 14 and the optical axis of the second condenser lens 15 are on one straight line. The first condenser lens 14 is arranged such that the incident direction of light at the center of the region where the light reflected by the plurality of mirrors 13 enters through the light refracting member 18 and the optical axis of the first condenser lens 14 are parallel to each other.

Next, the optical operation of the optical module 1a will be described.

As similar to the first embodiment, each laser diode 11 emits light toward the first collimating lens 16 and the second collimating lens 17 corresponding to the respective laser diodes 11. The light emitted from each second collimating lens 17 is incident on each corresponding mirror 13. Each mirror 13 reflects incident light as described below.

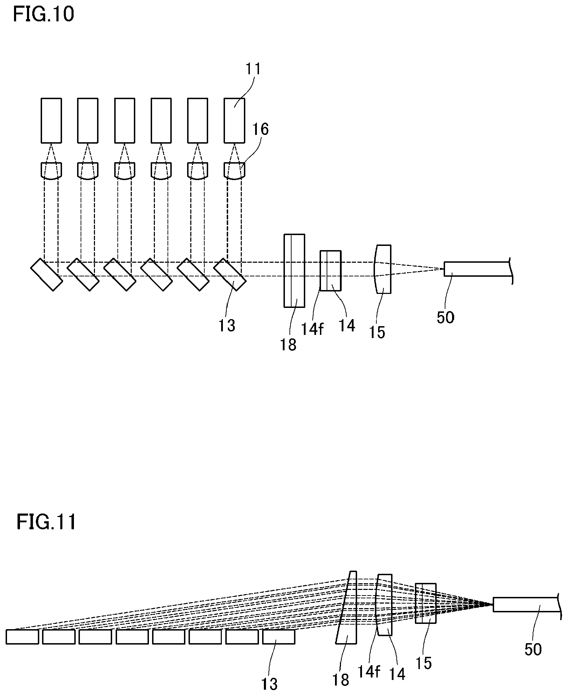

FIG. 10 is a plan view showing an optical path of light reflected by the mirror 13 shown in FIG. 7. FIG. 11 is a side view showing the optical path of light reflected by the mirror 13 shown in FIG. 7. In FIGS. 10 and 11, only a part of the members provided in the optical module 1a is schematically shown, and the optical paths of light emitted from each laser diode 11 are shown by broken lines. The first condenser lens 14 and the second condenser lens 15 are fixed to the submount 4 via a pedestal (not shown).

The reflection surface 13r of the mirror 13 of the present embodiment is inclined as described above, and can reflect incident light in an oblique direction with respect to the surface 4f of the submount 4. Therefore, as shown in FIGS. 10 and 11, the light reflected by each mirror 13 propagates through a space on the opposite side to the submount 4 of another mirror 13 arranged adjacent to the first condenser lens 14 side. In this manner, the plurality of mirrors 13 can reflect each light emitted from the respective laser diodes 11 so that the fast axis directions are aligned with each other and arrayed. In the present embodiment, the plurality of mirrors 13 reflect each light emitted from the respective laser diodes 11 such that the propagation directions are parallel to each other. That is, when the pieces of light emitted from the respective laser diodes 11 are parallel to each other, the reflection surfaces 13r of the respective mirror 13 have substantially the same angle with respect to the surface 4f of the submount 4.

The light reflected by the plurality of mirrors 13 as described above is incident on the light refracting member 18. The light incident on the light refracting member 18 is refracted such that the propagation directions of the respective pieces of light reflected by the plurality of mirrors 13 approach parallel to the optical axis of the first condenser lens 14 as shown in FIG. 9. Accordingly, light substantially parallel to the optical axis is incident on the first condenser lens 14. The pieces of light emitted from the plurality of laser diodes 11 are arrayed in the fast axis direction by the reflection of the plurality of mirrors 13 as described above. Accordingly, when the pieces of light are incident on the incident surface 14f of the first condenser lens 14, the light is arrayed such that the fast axis directions are aligned as similar to the first embodiment.

The light incident on the first condenser lens 14 is condensed in the fast axis direction as described above. The light emitted from the first condenser lens 14 is incident on the second condenser lens 15, and the slow axis direction of the light is condensed by the second condenser lens 15. The light condensed by the second condenser lens 15 enters the core of the optical fiber 50 and propagates through the optical fiber 50. Thus, light is emitted from the other end of the optical fiber 50.

Next, the operation of the optical module 1a will be described.

In the optical module 1a, the plurality of laser diodes 11 are arranged on the same plane. The fixed surface 13f of each mirror 13 is fixed to the fixation surface 40 perpendicular to the plane in the projection 4p that projects from the plane on which the plurality of laser diodes 11 are arranged to the side on which the mirror 13 is provided. When the plurality of laser diodes 11 are arranged on the same plane, the fixed surface 13f of the mirror 13 is fixed to the fixation surface 40 in this manner, so that the fixed surface 13f of the mirror 13 can be parallel to a direction in which the mirror 13 and the reflected light reflected by another mirror 13 overlap with each other. Therefore, as in the first embodiment, the change in the optical path due to heat and humidity can be prevented.

Although the present invention has been described above with the embodiment as an example, the present invention is not limited to this.

For example, in the first embodiment, description has been made with an example where the fixed surfaces 13f of the certain number of mirrors 13 and the fixation surfaces 40 to which these fixed surfaces 13f are fixed are parallel to a direction in which the mirrors 13 and the reflected light reflected by the other mirror 13 overlap with each other. However, the present invention is not limited to the embodiment. It is sufficient that the fixed surfaces 13f of the certain number of mirrors 13 and the fixation surface 40 to which these fixed surfaces 13f are fixed are not perpendicular to the direction in which the mirror 13 and the reflected light reflected by another mirror overlap with each other. In a case where the fixed surface of the mirror and a fixation surface to which the fixed surface is fixed are perpendicular to the direction in which the mirror and the reflected light reflected by another mirror overlap with each other, when the volume of the adhesive for fixing the fixed surface changes, the mirror is displaced in a direction substantially perpendicular to the fixed surface. That is, the mirror is displaced in the direction in which the mirror and the reflected light reflected by another mirror overlap with each other. As a result, the distance between the mirror and the reflected light reflected by another mirror becomes smaller, and if the displacement of the mirror becomes large, the propagation of the reflected light may be disturbed. However, as described above, if the fixed surface 13f and the fixation surface 40 of the mirror 13 are not perpendicular to the direction in which the mirror 13 and the reflected light reflected by another mirror 13 overlap with each other, in a case where the volume of the adhesive fixing the fixed surface 13f changes, the direction in which the mirror 13 is displaced is different from the direction in which the mirror 13 and the reflected light reflected by another mirror 13 overlap with each other. That is, displacement of the mirror 13 in the direction approaching the reflected light reflected by another mirror 13 is prevented as compared with the above example. Therefore, the light propagation can be prevented from being disturbed by the change in volume of the adhesive fixing the mirror 13.

In the second embodiment, description has been made with an example where the fixed surface 13f of the mirror 13 is fixed to the side surface 4pf of the projection 4p perpendicular to the plane on which the laser diode 11 is arranged. However, the present invention is not limited to the embodiment. It is sufficient that the side surface 4pf of the projection 4p is not parallel to the plane on which the laser diode 11 is arranged. When the plurality of laser diodes 11 are arranged on the same plane, the fixed surface 13f of the mirror 13 is fixed to the side surface 4pf of the projection 4p as described above, so that the fixed surface 13f of the mirror 13 can be non-perpendicular to the direction in which the mirror 13 and the reflected light reflected by another mirror 13 overlap with each other. Therefore, the light propagation can be prevented from being disturbed by the volume change of the adhesive fixing the mirror 13 as described above.

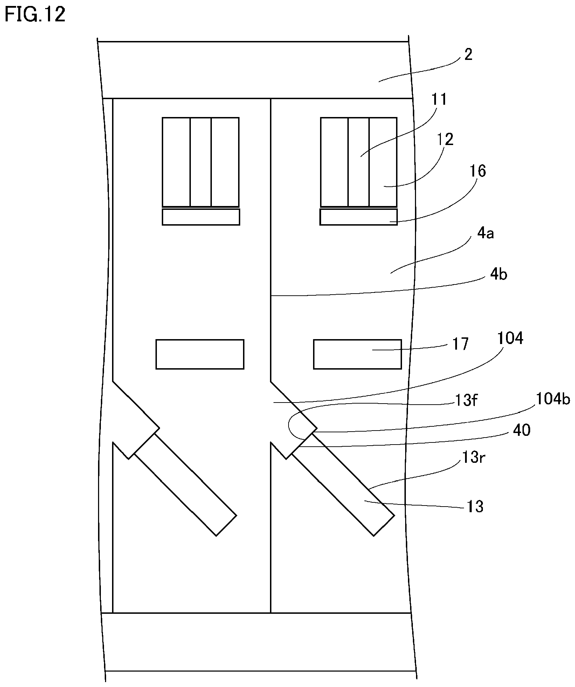

In the first embodiment, description has been made with an example where the mirror 13 is fixed to the second surface 4bb of the side wall 4b that cannot be viewed from the laser diode 11 side. However, the present invention is not limited to the embodiment. FIG. 12 is a view showing an optical module according to a modification of the present invention from the same viewpoint as FIG. 3. In the optical module according to the present modification, a block portion 104 projecting from the side wall 4b is formed on the optical axis side of the light emitted from the laser diode 11. The block portion 104 may be integrally formed with the other portion of the submount 4 by cutting or the like, and may be integrated with the submount 4 after being formed separately from the other portion of the submount 4 to be a part of the submount 4. The end face on the optical axis side of the light emitted from the laser diode 11 in the block portion 104 is an inclined surface 104b inclined similarly to the second surface 4bb.

In the first embodiment, description has been made with an example where the mirror 13 is fixed to the side wall 4b. However, also in the first embodiment, as similar to the second embodiment, the projection 4p may be provided on the parallel surface 4a, and the mirror 13 may be fixed to the projection. In the first and second embodiments, although description has been made with an example where the mirror 13 is fixed by one fixed surface 13f, the surface facing the fixed surface 13f in the mirror 13 may also be fixed by providing a projection similar to the projection 4p in the submount 4, or the like.

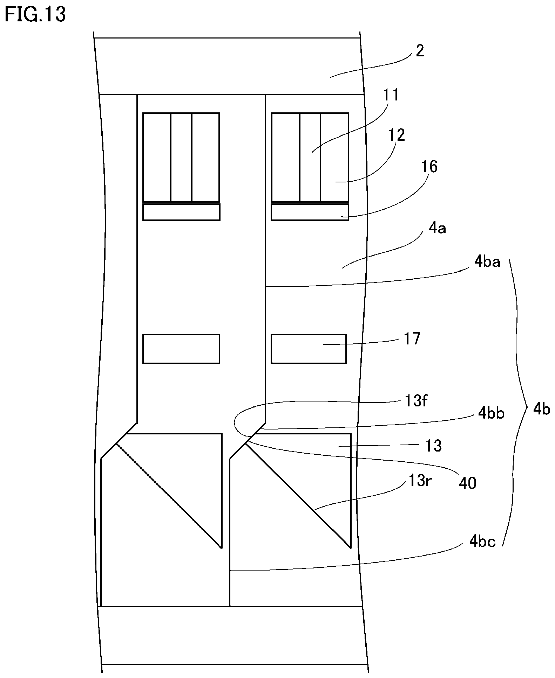

In the first and second embodiments described above, although description has been made with an example where the mirror 13 is a glass body having a reflecting film formed on the surface, the mirror 13 is not limited particularly as long as it is a member that can withstand the use of an optical module and can reflect light in a predetermined direction. FIG. 13 is a view showing an optical module according to another modification of the present invention from the same viewpoint as FIG. 3. The optical module according to the present modification differs from the first embodiment in that a prism is used as the mirror 13. The mirror 13 of the present modification is a triangular prism, and one corner of the triangle is cut to form the fixed surface 13f. When such a prism is used for the mirror 13, the reflectance of light from the laser diode 11 at the reflection surface 13r can be increased.

In the first and second embodiments, although description has been made with an example where the first collimating lens 16 is fixed on the laser mount 12, the first collimating lens 16 and the mirror 13 may be fixed to the surface integrally formed. For example, in the case of the first embodiment, the first collimating lens 16 may be fixed to the first surface 4ba of the side wall 4b. In the case of the second embodiment, the projection 4p may be extended to a portion where the first collimating lens 16 is arranged, and the first collimating lens 16 may be fixed to the projection 4p. By fixing the first collimating lens 16 and the mirror 13 to the integrally formed surface in this manner, the relative positional shift between the first collimating lens 16 and the mirror 13 can be prevented.

The light refracting member 18 is not an essential component in the second embodiment. When the light refracting member 18 is not provided, for example, it is sufficient that the optical axes of the first condenser lens 14, the second condenser lens 15, and the optical fiber 50 are aligned to the incident direction of the light incident on the first condenser lens 14, the second condenser lens 15, and the optical fiber 50.

In the first and second embodiments described above, description has been made with an example where the light reflected by each mirror 13 can be prevented from being blocked by another mirror 13. However, it is sufficient that at least part of the light reflected by each mirror 13 is not blocked by another mirror 13, and another part of the light may be blocked by another mirror 13. The light reflected by each mirror 13 may partially overlap each other.

In the first and second embodiments, as shown in FIG. 6, pieces of light emitted from the plurality of laser diodes 11 and reflected by the plurality of mirrors 13 overlap with each other when viewed from the fast axis directions of the respective pieces of light. However, the present invention is not limited to such an embodiment. It is sufficient that the light emitted from each light emitting element is reflected by the plurality of mirrors so as to overlap with part of the light emitted from at least one of other light emitting elements when viewed from the fast axis direction of each light.

As described above, according to the present invention, an optical module capable of preventing a change in an optical path due to heat or humidity is provided, and can be used in the field of, for example, a fiber laser device.

### Reference Signs List

- 1, 1a: optical module
- 2: base plate
- 3: lid
- 4: submount
- 4a: parallel surface
- 4b: side wall
- 4f: surface
- 4p: projection
- 4pf: side surface
- 11: laser diode
- 12: laser mount
- 13: mirror
- 13f: fixed surface
- 13r: reflection surface
- 14: first condenser lens
- 15: second condenser lens
- 16: first collimating lens
- 17: second collimating lens
- 18: light refracting member
- 40: fixation surface
- 50: optical fiber

## Claims

1. An optical module comprising:
a plurality of light emitting elements;
a plurality of mirrors each having a reflection surface that reflects each light emitted from each of the light emitting elements; and
a mount on which the plurality of light emitting elements are arranged on a side of one surface,
wherein a certain number of mirrors of the plurality of mirrors are arranged at a position overlapping reflected light reflected by another mirror of the plurality of mirrors when the one surface of the mount is viewed in plan view,
each of the certain number of mirrors has a fixed surface fixed to the mount with an adhesive,
the fixed surface is perpendicular to the reflection surface, and
a fixation surface of the mount to which the fixed surface is fixed and the fixed surface are not perpendicular to a direction in which the certain number of mirrors and the reflected light overlap with each other when the one surface of the mount is viewed in plan view.

2. The optical module according to claim 1,
wherein the fixation surface and the fixed surface are parallel to a direction in which the certain number of mirrors and the reflected light overlap with each other.

3. The optical module according to claim 1 or 2,
wherein the one surface of the mount is formed in a step shape,
the plurality of light emitting elements are arranged one by one on each step of the mount formed in a step shape, and
the fixation surface is formed on a side wall formed between adjacent steps.

4. The optical module according to claim 1 or 2,
wherein the plurality of light emitting elements are arranged on the same plane, and
the fixation surface is formed on a side surface non-parallel to the plane in a projection projecting to a side on which the mirror is provided from the plane.

5. The optical module according to any one of claims 1 to 4,
wherein the fixation surface is not parallel to an optical axis of light emitted from the light emitting elements.

6. The optical module according to any one of claims 1 to 5,
wherein a collimating lens that collimates light emitted from the light emitting elements is provided between the light emitting element and the mirror, and
the collimating lens and the mirror are fixed to an integrally formed surface.

7. The optical module according to any one of claims 1 to 6,
wherein the direction in which the certain number of mirrors and the reflected light overlap with each other is a direction perpendicular to the one surface of the mount.
